Europäisches Patentamt

European Patent Office

Office européen des brevets

(11) Publication number: **0 082 331**
**B1**

(12) **EUROPEAN PATENT SPECIFICATION**

(45) Date of publication of patent specification: **08.06.88**

(51) Int. Cl.⁴: **H 01 L 29/90**

(21) Application number: **82110812.3**

(22) Date of filing: **23.11.82**

(54) Subsurface avalanche breakdown Zener diode.

(30) Priority: **22.12.81 US 333547**

(43) Date of publication of application:
**29.06.83 Bulletin 83/26**

(45) Publication of the grant of the patent:
**08.06.88 Bulletin 88/23**

(84) Designated Contracting States:
**DE FR GB**

(56) References cited:
**EP-A-0 017 022**
**FR-A-2 172 191**
**GB-A-2 061 003**

**PATENTS ABSTRACTS OF JAPAN, vol. 7, no. 94 (E-171) 1239r, 20th April 1983; & JP - A - 58 16 574 (HITACHI SEISAKUSHO K.K.) 31-01-1983**

(73) Proprietor: **International Business Machines Corporation**
**Old Orchard Road**
**Armonk, N.Y. 10504 (US)**

(72) Inventor: **Muggli, Raymond Allen**
**7030 Via Del Rio**
**San Jose California 95139 (US)**

(74) Representative: **Hobbs, Francis John**
**IBM United Kingdom Limited Intellectual Property Department Hursley Park Winchester Hampshire SO21 2JN (GB)**

Courier Press, Leamington Spa, England.

# 0 082 331

**Description**

This invention relates to zener diode semiconductor devices, and more particularly to subsurface avalanche breakdown zener diodes.

The term zener diode has long been applied to two-electrode semiconductor devices operating with respect to the phenomena of the breakdown in solid dielectrics below approximately 5 volts, and of the avalanche effect corresponding to the Townsend discharge effect in dielectrics at potentials above approximately 5 volts. Zener diode devices are widely used as potential or "voltage" regulating devices, particularly in reference potential generating circuitry. Conventional IC devices very frequently include a number of zener diode devices, a number of transistor devices, and auxiliary circuit components and connections on a single semiconductor wafer or chip.

As the electronics arts have progressed, better and better zener diode devices and circuit arrangements have been developed. Examples of such improved zener diode circuits are found in the technical literature. There have been problems however with the prior art devices, for example, especially with respect to variations of the breakdown voltage, as a function of time and/or changes in temperature. It has been suggested that the causes of instability are related to the presence of the passivating insulating layer of silicon dioxide which lies adjacent to the outer silicon surface where avalance breakdown takes place in conventional zener diode devices. Various proposals for fabricating zener diode devices with subsurface avalanche breakdown regions have been published. U.S. Patent 3,881,179 is directed to a zener diode structure wherein the avalance breakdown is subsurface due to an enhanced p diffusion under an $n^+$ diffusion, but wherein there is a pn junction at the surface over which there is an electric field tending to ionize contaminants on that surface.

U.S. patent 4,079,402 is directed to a somewhat similar structure, but wherein an ion implanted layer is arranged to establish the avalance breakdown below the surface, and wherein there also is a portion of the p-n junction at the facing surface. A pinch resistance component also exists resulting in a high dynamic impedance.

A lower dynamic impedance is provided by the structure disclosed in U.S. Patent 4,136,349. This structure in fact has a part of the avalanche breakdown junction at the surface but its effect is mitigated by a shallow doping extending laterally of the junction.

The Japanese patent 54-6480 discloses a zener diode having the p-n breakdown junction entirely beneath the outer surface. It is formed by first burying a subcollector layer in two epitaxial layer growing steps and diffusing semiconductor material of the same conductivity type from the outer surface to contact the subcollector. Material of the opposite conductivity type is then diffused over the larger of the two like material diffusions to create a p-n breakdown junction beneath the outer surface of the structure. This structure is not compatible with Complementary Metal Oxide Semiconductor (CMOS) fabrication techniques. A zener diode according to the first part of claim 1 has in substance been described in EP—A—0017022.

The invention seeks to provide a subsurface avalance breakdown zener diode structure which is compatible with CMOS fabrication techniques.

In accordance with the invention, a subsurface avalance breakdown zener diode formed in a semiconductor substrate of one conductivity type material, comprises a first region of the opposite conductivity type material formed from the outer surface of said semiconductor substrate to a predetermined depth therein, a second region of enhanced conductivity material of the opposite conductivity type formed centrally in said first region from the outer surface of the substrate to a depth less than said predetermined depth, a pair of regions of enhanced conductivity material of said one conductivity type disclosed one on each side of said first region extending down from the outer surface of the substrate and electrical contacts made respectively to the first region and one of said pair of regions and being characterised by said pair of regions being spaced from said first region and by a shallow third region extending down from said outer surface of the same enhanced conductivity material as that of said pair of regions, the third region interconnecting said pair of regions and covering the second region so that a buried PN junction is formed between the third region and the second region.

How the invention can be carried out will now be described by way of example, with reference to the accompanying drawings, in which:—

Fig. 1 is a diagrammatic plan view of a zener diode embodying the invention;

Fig. 2 is a cross-section taken on line 2—2 of Fig. 1;

Fig. 3 is a cross-section taken on line 3—3 of Fig. 1; and

Fig. 4 is a graphical representation of the doping concentration profile below the outer semiconductor surface of a zener diode according to the invention.

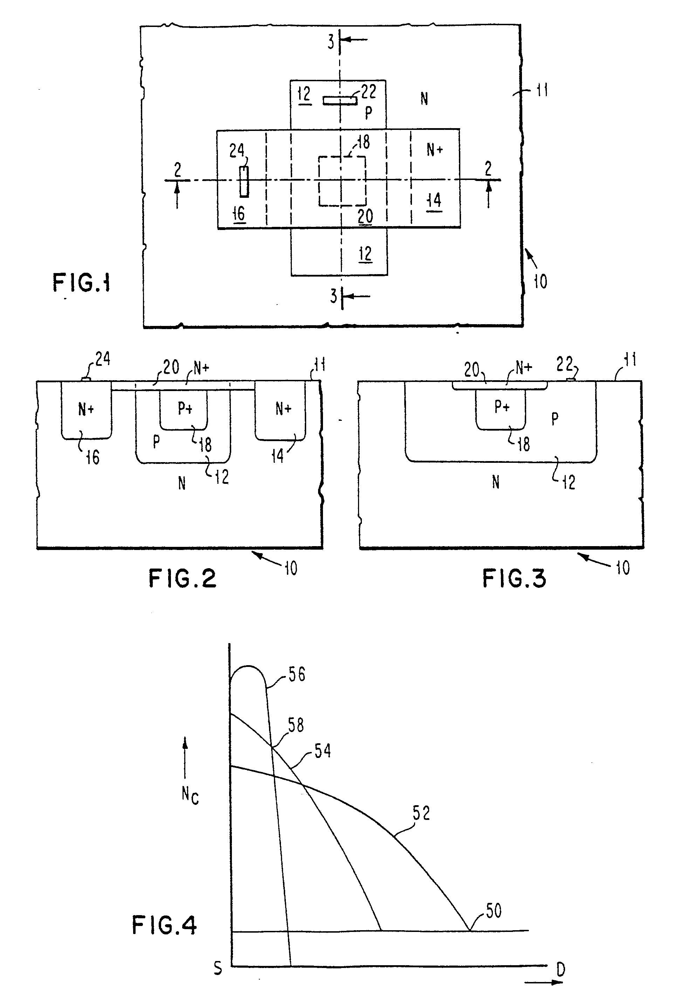

An embodiment of a zeneor diode fabricated according to the invention is represented in Figs. 1, 2 and 3. This depiction, in the interest of clarity, is that of an idealized structure. Fig. 1 is substantially in the form of superimposed mask outlines as used in a conventional CMOS fabrication process. Similarly, Figs. 2 and 3 are substantially vertical projections of the mask outlines. Those skilled in the art will recognize the advantages of this particular depiction and immediately will correlate with the configuration as actually realised. A zener diode embodying the invention and other electronic semiconductor components and circuitry used therewith are formed in a semiconductor substrate 10. The substrate 10 is a wafer of

2

substantially pure silicon doped with a negative dopant of given concentration denoted here as N. The zener diode structure will be laid down in a sequence of steps which will be the same sequence of steps as for other transistor devices and semiconductor circuits components. In a conventional manner, a quantity of semiconductor material of opposite conductivity type denoted here as P$^+$, is deposited on the substrate 10 and diffused therein to form a conventional "P-well" 12 to a predetermined depth from the outer surface 11 of the substrate 10. This P-well 12 is of elongate rectangular shape and is diffused in the same step as for an N-channel FET. The next step in the sequence of steps for forming the zener diode structure is a simultaneous diffusing of enhanced conductivity material of the first conductivity type, shown here as N$^+$ type, in two elongate regions 14 and 16 spaced apart from the first region 12 and penetrating to a prearranged depth of the order of two-thirds of the predetermiend depth of the P-well 12. A centrally located region 18 of P$^+$ material is diffused into the P-well 12 to a depth of the same order as the prearranged depth of the two regions 14 and 16. A layer 20 of N$^+$ material is deposited, preferably by ion implantation, between the regions 14 and 16, over the central diffused region 18 and over part of the P-well 12 to a depth of the order of one-fourth of the predetermined depth. The upper part of the centrally located region 18 is converted from the diffused P$^+$ material to a region of semiconductor material of the opposite conductivity type, and the zener diode PN junction is located at the interface between the P$^+$ region 18 and the N$^+$ region 20. The area of this interface is sufficiently large that the current density is relatively low. The entire P$^+$N$^+$ junction is completely beneath the outer surface 11. An anode contact 22 is made to a part of the first region 12 which is not covered by the layer 20 and a cathode contact 24 is made to the region 16.

While those skilled in the art will fabricate zener diode structures according to the invention having dimensions with which they are familiar, some typical dimensions are listed in Table I below.

TABLE I

| | |
|---|---|
| Substrate 10 (depth-1.15 mm) | 1150 microns |
| Cathode region 20 (depth at zener junction) | 0.5 micron |
| Anode region 12 (depth below surface) | 1.5 microns |
| Well 12 (at surface) | 36×10 microns |
| Cathode region 20 (at surface) | 26×26 microns |
| Anode region 18 (at zener junction) | 20×20 microns |

Zener diodes according to the description above have been made with the concentrations given in Table II below.

TABLE II

| | |
|---|---|
| Substrate 10 arsenic doped | $10^{15}$ atoms/cm$^3$ P$^-$ |
| Anode region 18 Boron dopant | $10^{17}$ atoms/cm$^3$ P |
| Cathode region 20 Arsenic dopant | $10^{20}$ atoms/cm$^3$ N$^+$ |

It should be understood that diffusion and ion implantation processes are interchangeable in the making of zener diodes according to the invention. Also, the zener diodes according to the invention can be fabricated with the opposite conductivity by interchanging P material for N material. However, owing to the well-known superiority of N-channel CMOS FET, the substrate more often will be of N-type conductivity.

Fig. 4 is a graphical representation of the doping concentration N$_c$ related to depth below the outer surface of the CMOS IC device according to the invention. The curve 50 represents the substrate concentration reference level. The curve 52 represents a profile down the centre of the P-well. The curve 54 represents a P$^+$ profile, while the curve 56 represents a N$^+$ profile. The avalanche breakdown occurs at the concentrations represented by the crossover point 58.

## 0 082 331

### Claims

1. A subsurface avalanche breakdown zener diode formed in a semiconductor substrate (10) of one conductivity type material, comprising a first region (12) of the opposite conductivity type material formed from the outer surface (11) of said semiconductor substrate to a predetermined depth therein, a second region (18) of enhanced conductivity material of the opposite conductivity type formed centrally in said first region (12) from the outer surface of the substrate to a depth less than said predetermined depth, a pair of regions (14, 16) of enhanced conductivity material of said one conductivity type disposed one on each side of said first region (12) extending down from the outer surface of the substrate and electrical contacts (22, 24) made respectively to the first region (12) and one (16) of said pair of regions (14, 16) and being characterised by said pair of regions (14, 16) being spaced from said first region (12) and by a shallow third region (20) extending down from said outer surface of a same enhanced conductivity material as that of said pair of regions (14, 16), the third region (20) interconnecting said pair of regions (14, 16) and covering the second region (18) so that a buried PN junction is formed between the third region (20) and the second region (18).

2. A zener diode as claimed in claim 1, in which the first region and said pair of regions are substantially rectangular, the length of the first region being greater than that of said pair of regions.

3. A zener diode as claimed in claim 1 or claim 2, in which the depth of said pair of regions is of the same order as the depth of the second region.

4. A zener diode as claimed in any preceding claim, in which said one conductivity type is N type, said opposite conductivity type is P type, the electrical contact to the first region is an anode contact, and the other electrical contact is a cathode contact.

5. A zener diode as claimed in any preceding claim formed in a complementary metal oxide semiconductor integrated circuit.

### Patentansprüche

1. Zener-Diode mit Lawinendurchbruch unter der Oberfläche, welche Zener-Diode in einem Halbleitersubstrat (10) aus Material des einen Leitungstyps ausgebildet ist und einen ersten Bereich (12) aus Material des entgegengesetzten Leitungstyps, welcher von der äußeren Oberfläche (11) des Halbleitersubstrats bis in eine bestimmte Tiefe hinab darin ausgebildet ist, einen zweiten Bereich (18) aus Material verstärkter Leitfähigkeit des entgegengesetzten Leitungstyps, welcher mittig in dem ersten Bereich (12) von der äußeren Oberfläche des Substrats bis in eine Tiefe hinab, die geringer als die bestimmte Tiefe ist, ausgebildet ist, ein Paar von Bereichen (14, 16) aus Material verstärkter Leitfähigkeit des einen Leitungstyps, welche jeweils einzeln zu beiden Seiten des ersten Bereichs (12) angeordnet sind und sich von der äußeren Oberfläche des Substrats nach unten erstrecken, und elektrische Kontakte (22, 24) zum ersten Bereich (12) und zu einem (16) des Paares von Bereichen (14, 16) umfaßt und gekennzeichnet ist dadurch, daß das Paar von Bereichen (14, 16) vom ersten Bereich (12) im Abstand liegt, und durch einen sich von der äußeren Oberfläche nach unten erstreckenden seichten dritten Bereich (20) aus dem gleichen Material verstärkter Leitfähigkeit wie das des Paares von Bereichen (14, 16), wobei der dritte Bereich (20) das Paar von Bereichen (14, 16) verbindet und den zweiten Bereich (18) abdeckt, so daß ein begrabener PN-Übergang zwischen dem dritten Bereich (20) und dem zweiten Bereich (18) ausgebildet wird.

2. Zener-Diode nach Anspruch 1, bei welcher der erste Bereich und das Paar von Bereichen im wesentlichen rechteckig sind, wobei die Länge des ersten Bereichs größer als diejenige des Paares von Bereichen ist.

3. Zener-Diode nach Anspruch 1 oder 2, bei welcher die Tiefe des Paares von Bereichen von der gleichen Größenordnung wie die Tiefe des zweiten Bereichs ist.

4. Zener-Diode nach irgendeinem vorstehenden Anspruch bei welcher der eine Leitungstyp N-Leitung ist, der entgegengesetzte Leitungstyp P-Leitung ist, der elektrische Kontakt zum ersten Bereich ein Anoden-Kontakt ist, und der andere elektrische Kontakt ein Kathoden-Kontakt ist.

5. Zener-Diode nach irgendeinem vorstehenden Anspruch, welche in einer integrierten Komplementär-Metalloxid-Halbleiter-Schaltung ausgebildet ist.

### Revendications

1. Diode Zener à amorçage par avalanche au-dessous de la surface, formée dans un substrat semi-conducteur (10) d'une matière d'un type de conductivité, comportant une première région (12) d'une matière du type opposé de conductivité formée à partir de la surface extérieure (11) dudit substrat semi-conducteur jusqu'à une profondeur prédéterminée dans ce dernier, une seconde région (18) d'une matière de conductivité améliorée du type opposé de conductivite formé au centre de ladite première région (12) à partir de la surface extérieure de substrat jusqu'à une profondeur inférieure à ladite profondeur prédéterminée, deux régions (14, 16) de matière de conductivité améliorée dudit premier type de conductivité disposées l'une de chaque côté de ladite première région (12), s'étendant vers le bas à partir de la surface extérieure du substrat et des contacts électriques (22, 24) réalisés respectivement sur la

**0 082 331**

première région (12) et l'une desdites régions (14, 16), caractérisé en ce que cesdites deux régions (14, 16) sont espacées de ladite première région (12) et en ce qu'une troisième région (20) peu profonde s'étendant vers le bas à partir de ladite surface extérieure de la même matière de conductivité améliorée que celle desdites deux régions (14, 16), la troisième région (20) interconnectant lesdites deux régions (14, 16) et recouvrant la seconde région (18) de manière qu'une jonction PN encastrée soit formée entre la troisième région (20) et la seconde région (18).

2. Diode Zener selon la revendication 1, dans laquelle la première région et lesdites deux régions sont pratiquement rectangulaires, la longuer de la première région étant supérieure à celle desdites régions.

3. Diode Zener selon la revendication 1 ou 2, dans laquelle la profondeur desdites deux régions est du même ordre que la profondeur de la seconde région.

4. Diode Zener selon l'une quelconque des revendications précédentes, dans laquelle ledit premier type de conductivité est le type N, le type opposé de conductivité est le type P, le contact électrique avec la première région est un contact d'anode et l'autre contact électrique est un contact de cathode.

5. Diode Zener selon l'une quelconque des revendications précédentes, formée dans un circuit intégré à semi-conducteur à oxyde métallique complémentaire.

5

FIG.1

FIG.2

FIG.3

FIG.4